Europäisches Patentamt

European Patent Office

Office européen des brevets

(11) Veröffentlichungsnummer: **0 407 938 A2**

# EUROPÄISCHE PATENTANMELDUNG

(21) Anmeldenummer: **90113081.5**

(22) Anmeldetag: **09.07.90**

(51) Int. Cl.5: **H03K 17/08, H02H 7/20**

(30) Priorität: **13.07.89 DE 3923170**

(43) Veröffentlichungstag der Anmeldung:
**16.01.91 Patentblatt 91/03**

(84) Benannte Vertragsstaaten:
**DE FR GB IT SE**

(71) Anmelder: **Siemens Aktiengesellschaft**
**Wittelsbacherplatz 2**
**D-8000 München 2(DE)**

(72) Erfinder: **Tihanyi, Jenoe, Dr.Ing.**
**Hartelstrasse 6**
**D-8000 München 21(DE)**

(54) **Schaltungsanordnung zum Schutz von elektrischen Geräten gegen Überspannung.**

(57) Zum Schutz von elektrischen Geräten gegen Überspannung wird die Laststrecke eines Leistungshalbleiterbauelements (2) zwischen die Eingangs- (1) und Ausgangsklemme (3) der Schutzschaltungsanordnung geschaltet. Der durch den Leistungshalbleiter (2) gebildete Schalter ist im normalen Betriebszustand geschlossen. Tritt an der Eingangsklemme (1) eine Überspannung auf, so wird diese von einer parallel zum Schalter (2) liegenden Meßschaltung (4) detektiert und der Schalter (2) geöffnet. Ein zwischen der Ausgangsklemme (3) und einer zweiten Eingangsklemme (5) liegende Kondensator (6) hält für die Dauer der Überspannung die Ausgangsspannung an der Ausgangsklemme (3) konstant. Eine zusätzliche Schaltungsanordnung (7) zum Betreiben des Leistungshalbleiters (2) ist vorgesehen.

FIG 1

EP 0 407 938 A2

## SCHALTUNGSANORDNUNG ZUM SCHUTZ VON ELEKTRISCHEN GERÄTEN GEGEN ÜBERSPANNUNG.

Die Erfindung betrifft eine Schaltungsanordnung zum Schutz von elektrischen Geräten gegen Überspannung.

Eine solche Schaltungsanordnung ist zum Beispiel aus der DE-PS 30 34 927 C 2 bekannt. Die darin vorgeschlagene Schaltungsanordnung schützt einen Leistungs-MOSFET gegen Überlastung. Sie läßt sich auch zum Schutz von elektrischen Geräten gegen Überspannung verwenden. Eine solche Schaltungsanordnung weist folgende Eigenschaften auf: Die Ausgangsspannung wird bei Überlastung gleich Null. Die Last wird also abgeschaltet. Zum Einschalten der Last muß die Schaltung über einen Schalter wieder in Betrieb genommen werden.

Der Erfindung liegt die Aufgabe zugrunde, eine solche Schaltungsanordnung derart weiterzubilden, daß auch bei Überspannung am Eingang der Schaltungsanordnung eine konstante Ausgangsspannung an der Ausgangsklemme gewährleistet ist.

Die Erfindung ist gekennzeichnet durch die folgenden Merkmale:

a) Eine erste Eingangsklemme (1) ist über ein durch Feldeffekt steuerbares Leistungshalbleiterbauelement (2) mit einer Ausgangsklemme (3) verbunden,

b) dem durch Feldeffekt steuerbaren Leistungshalbleiterbauelement (2) ist eine Meßschaltungsanordnung (4) parallel geschaltet, die eine Überspannung zwischen der Eingangsklemme (1) und der Ausgangsklemme (3) detektiert und über eine Steuerleitung das durch Feldeffekt steuerbare Leistungshalbleiterbauelement (2) bei Überspannung sperrt,

c) eine zweite Eingangsklemme (5) ist mit einem Anschluß eines Kondensators (6) verbunden,

d) der andere Anschluß des Kondensators (6) ist mit der Ausgangsklemme (3) verbunden,

e) das durch Feldeffekt steuerbare Leistungshalbleiterbauelement (2) hat einen Steuereingang, der mit der Steuerleitung der Meßschaltungsanordnung (4) verbunden ist,

f) die Laststrecke des Leistungshalbleiterbauelements (2) ist über einen ersten Anschluß mit der ersten Eingangsklemme (1) und über einen zweiten Anschluß mit der Ausgangsklemme (3) verbunden,

g) eine weitere Schaltungsanordnung (7), die die Steuerspannung für das durch Feldeffekt steuerbare Leistungshalbleiterbauelement (2) erzeugt.

Weiterbildungen der Schaltungsanordnung sind Gegenstand der Unteransprüche.

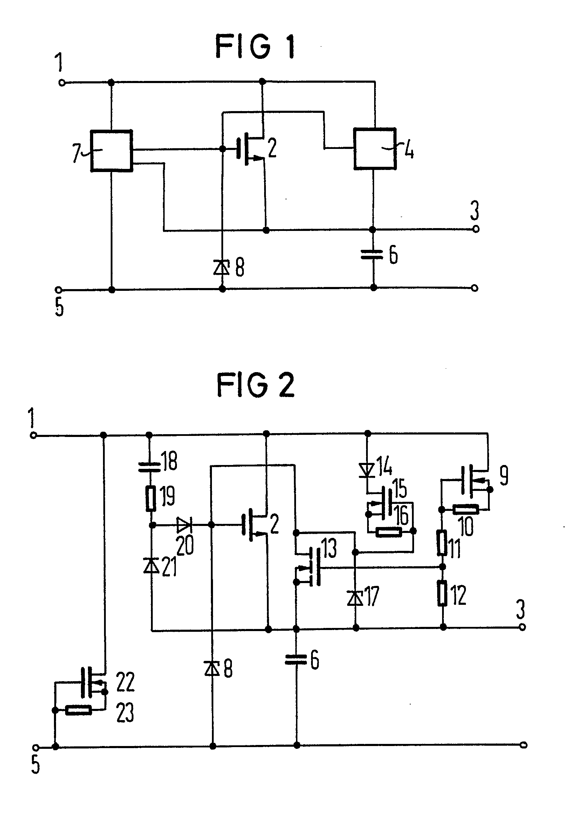

Die Erfindung wird anhand einer Prinzipschaltungsanordnung in Verbindung mit FIG 1 und eines Ausführungsbeispiels in Verbindung mit FIG 2 näher erläutert.

Die Schutzschaltungsanordnung nach FIG 1 weist ein Leistungs halbleiterbauelement 2 auf, dessen Laststrecke über einen ersten Anschluß mit einer Eingangsklemme 1 und über einen zweiten Anschluß mit einer Ausgangsklemme 3 verbunden ist. Das Leistungshalbleiterbauelement 2 kann z.B. ein IGBT (Insulated Gate Bipolar Transistor) oder ein MOSFET sein. Im folgenden wird für das Leistungshalbleiterbauelement 2 ein IGBT angenommen. Parallel zur Laststrecke des IGBT 2 ist eine Meßschaltungsanordnung 4 geschaltet. Eine Steuerleitung verbindet die Meßschaltungsanordnung 4 mit dem Steueranschluß des IGBT 2. Eine zweite Eingangsklemme 5 ist vorgesehen, die mit einem Anschluß eines Kondensators 6 verbunden ist. Der andere Anschluß des Kondensators 6 ist mit der Ausgangsklemme 3 verbunden. Zwischen der ersten Eingangsklemme 1 und der zweiten Eingangsklemme 5 liegt eine weitere Schaltungsanordnung 7, die eine Steuerspannung zum Einschalten des IGBT 2 erzeugt. Zwischen dem Steueranschluß des IGBT 2 und der zweiten Eingangsklemme 5 ist eine Zenerdiode 8 geschaltet.

Zur Funktionserläuterung sei angenommen, daß der IGBT 2 ausgeschaltet ist. Legt man eine gleichgerichtete ungeglättete Spannung an die Eingangsklemmen 1, 5 an, so wird über die Schaltungsanordnung 7 der IGBT 2 eingeschaltet und der Kondensator 6 über die Laststrecke des IGBT 2 auf die Sollspannung aufgeladen. Tritt an der Eingangsklemme 1 eine Überspannung auf, so wird diese, wenn sie einen bestimmten Schwellwert überschreitet, von der Meßschaltungsanordnung 4 detektiert. Der IGBT 2 wird über die Steuerleitung von der Meßschaltungsanordnung 4 gesperrt. Der IGBT 2 bleibt nun solange gesperrt, bis die Spannungsdifferenz zwischen der Eingangsklemme 1 und der Ausgangsklemme 3 den Schwellwert der Meßschaltungsanordnung 4 unterschreitet. Der Kondensator 6 gewährleistet, daß die Sollspannung für die Dauer der Überspannung an der Ausgangsklemme 3 anliegt.

FIG 2 zeigt ein Ausführungsbeispiel der Schaltungsanordnung nach FIG 1. Die Meßschaltungsanordnung (4 in FIG 1) wird dadurch gebildet, daß zwischen der ersten Eingangsklemme 1 und der Ausgangsklemme 3 die Reihenschaltung einer Stromquelle und zweier Widerstände 11, 12 geschaltet ist. Die Reihenschaltung der beiden Widerstände 11, 12 ist min einem Mittelabgriff versehen, der mit dem Gate-Anschluß eines Steuer-MOSFET 13 verbunden ist. Der Drain-Anschluß des Steuer-MOSFET 13 ist mit dem Steueranschluß des IGBT 2 verbunden. Der Source-Anschluß des Steuer-MOSFET 13 ist mit der Ausgangsklemme 3 verbunden.

Die Schaltungsanordnung (7 in FIG 1) zum Erzeugen der Steuerspannung für den IGBT 2 besteht aus der Reihenschaltung aus einem Kondensator 18, einem Widerstand 19 und einer Diode 20, die zwischen die Eingangsklemme 1 und dem Steueranschluß des IGBT 2 geschaltet ist. Die Reihenschaltung aus dem Widerstand 19 und der Diode 20 ist mit einem Mittelabgriff versehen. Zwischen der Ausgangsklemme 3 und diesem Mittelabgriff ist eine weitere Diode 21 geschaltet. Zwischen der ersten Eingangsklemme 1 und der zweiten Eingangsklemme 5 ist eine Stromquelle geschaltet. Die Stromquelle wird aus einem MOSFET 22 und einem Widerstand 23 gebildet.

Weiterhin ist eine Anlaufschaltungsanordnung vorgesehen, die beim Anlegen einer Versorgungsspannung den IGBT 2 leitend schaltet. Diese Schaltungsanordnung wird dadurch gebildet, daß zwischen der ersten Eingangsklemme 1 und dem Steueranschluß des IGBT 2 die Reihenschaltung aus einer Diode 14 und einer Stromquelle geschaltet ist. Die Stromquelle besteht aus einem MOSFET 15 und Widerstand 16. Zwischen den Steueranschluß des IGBT 2 und der Ausgangsklemme 3 ist eine Zenerdiode 17 geschaltet. Die Stromquellen in der Meßschaltungsanordnung 4 , der Schaltungsanordnung 7 zum Erzeugen der Steuerspannung und der Anlaufschaltungsanordnung werden derart gebildet, daß der Source-Anschluß des MOSFET 9, 15, 22 jeweils über einen Widerstand 10, 16, 23 mit dem Gate-Anschluß des MOSFET 9, 15, 22 verbunden ist.

Beim Anlegen einer Versorgungsspannung wird die Gate-Source-Kapazität des IGBT 2 über die Diode 14 und die Stromquelle 15, 16 schon mit der ersten Halblwelle aufgeladen und der IGBT 2 leitend gesteuert. Dadurch wird der Kondensator 6 auf seine Soll-Spannung aufgeladen. Über die Diode 21 und den Widerstand 19 wird der Kondensator 18 aufgeladen. Die Spannung am Kondensator 18 wird nun mit jeder von der Versorgungsspannung kommenden Halbwelle verschoben. Die so erhöhte Spannung am Kondensator 18 kann sich nun über den Widerstand 19 und die Diode 20 in die Gatesource-Kapazität des IGBT 2 entladen und diesen leitend halten.

Liegt an der ersten Eingangsklemme 1 eine Überspannung an, so fließt über den MOSFET 9 ein Strom durch die Reihenschal tung der Widerstände 11, 12 und erzeugt am Widerstand 12 einen Spannungsabfall, der den Steuer-MOSFET 13 leitend schaltet. Dadurch wird die Gatesource-Kapazität des IGBT 2 kurzgeschlossen, und der IGBT 2 wird gesperrt. Die Überspannung kann nun über die Stromquelle 22, 23 abfließen. Die Zenerdiode 17 schützt den IGBT 2, und die Zenerdiode 8 schützt den Kondensator 6 vor Überspannung. Der IGBT oder MOSFET kann z.B. zusätzlich mit einem Temperaturschutz versehen sein, wie es in der EP 0208970 AI beschrieben ist.

## Ansprüche

1. Schaltungsanordnung zum Schutz von elektrischen Geräten gegen Überspannung, **gekennzeichnet** durch die Merkmale:

a) eine erste Eingangsklemme (1) ist über ein durch Feldeffekt steuerbares Leistungshalbleiterbauelement (2) mit einer Ausgangsklemme (3) verbunden,

b) dem durch Feldeffekt steuerbaren Leistungshalbleiterbauelement (2) ist eine Meßschaltungsanordnung (4) parallel geschaltet, die eine Überspannung zwischen der Eingangsklemme (1) und der Ausgangsklemme (3) detektiert und über eine Steuerleitung das durch Feldeffekt steuerbare Leistungshalbleiterbauelement (2) bei Überspannung sperrt,

c) eine zweite Eingangsklemme (5) ist mit einem Anschluß eines Kondensators (6) verbunden,

d) der andere Anschluß des Kondensators (6) ist mit der Ausgangsklemme (3) verbunden,

e) das durch Feldeffekt steuerbare Leistungshalbleiterbauelement (2) hat einen Steuereingang, der mit der Steuerleitung der Meßschaltungsanordnung (4) verbunden ist,

f) die Laststrecke des Leistungshalbleiterbauelements ist über einen ersten Anschluß mit der ersten Eingangsklemme (1) und über einen zweiten Anschluß mit der Ausgangsklemme (3) verbunden,

g) eine weitere Schaltungsanordnung (7), die die Steuerspannung für das durch Feldeffekt steuerbare Leistungshalbleiterbauelement (2) erzeugt.

2. Schaltungsanordnung nach Anspruch 1, **dadurch gekennzeichnet**, daß das durch Feldeffekt steuerbare Leistungshalbleiterbauelement (2) ein IGBT ist.

3.Schaltungsanordnung nach Anspruch 1, **dadurch gekennzeichnet**, daß das durch Feldeffekt steuerbare Leistungshalbleiterbauelement (2) ein MOSFET ist.

4. Schaltungsanordnung nach Anspruch 1, **dadurch gekennzeichnet**, daß die Meßschaltung dadurch gebildet wird, daß:

a) eine Stromquelle und zwei Widerstände (11, 12) in Reihe geschaltet sind,

b) der erste Anschluß der Stromquelle mit der ersten Eingangsklemme (1) verbunden ist,

c) der andere Anschluß über die Reihenschaltung der beiden Widerstände (11, 12) mit der Ausgangsklemme (3) verbunden ist,

d) die Reihenschaltung der beiden Widerstände (11, 12) mit einem Mittelabgriff versehen ist, der mit dem Gate-Anschluß eines Steuer-MOSFET (13) verbunden ist,

e) der Drain-Anschluß des Steuer-MOSFET (13) mit dem Steueranschluß des Leistungshalbleiters (2) verbunden ist,

f) der Source-Anschluß des Steuer-MOSFET (13) mit dem zweiten Anschluß des Leistungshalbleiterbauelements (2) verbunden ist.

5. Schaltungsanordnung nach Anspruch 1, **dadurch gekennzeichnet**, daß die Schaltungsanordnung (7) zum Erzeugen der Steuerspannung dadurch gebildet wird, daß:

a) zwischen der ersten Eingangsklemme (1) und dem Steueranschluß des Leistungshalbleiterbauelements (2) die Reihenschaltung eines Kondensators (18) eines Widerstandes (19) und einer Diode (20) geschaltet ist,

b) die Reihenschaltung des Widerstandes (19) und der Diode (20) mit einem Mittelabgriff versehen ist, der über eine Diode (21) mit dem zweiten Anschluß des Leistungshalblei terbauelements (2) verbunden ist,

c) zwischen der ersten Eingangsklemme (1) und der zweiten Eingangsklemme (5) eine Stromquelle geschaltet ist.

6. Schaltungsanordnung nach Anspruch 1, **dadurch gekennzeichnet**, daß eine Anlaufschaltung vorgesehen ist, die beim Anlegen einer Versorgungsspannung das Lei stungshalbleiterbauelement (2) leitend schaltet.

7. Schaltungsanordnung nach Anspruch 6, **dadurch gekennzeichnet**, daß die Anlaufschaltungsanordnung derart gebildet ist, daß zwischen der ersten Eingangsklemme (1) und dem Steueranschluß des Leistungshalbleiterbauelements (2) die Reihenschaltung aus einer Diode (14) und einer Stromquelle geschaltet ist.

8. Schaltungsanordnung einem der Ansprüche 4, 5, 7, **dadurchgekennzeichnet**, daß die Stromquellen jeweils durch einen Depletion-MOSFET (9, 15, 22) gebildet werden, derart, daß der Source-Anschluß des Depletion-MOSFET (9, 15, 22) über jeweils einen Widerstand (10, 16, 23) mit dem Gate-Anschluß des Depletion-MOSFET (9, 15, 22) verbunden ist.

9. Schaltugnsanordnung nach Anspruch 1, **dadurch gekennzeichnet**, daß zwischen den Steueranschluß des Leistungshalbleiterbauelements (2) und der zweiten Eingangsklemme (5) eine Zenerdiode (8) geschaltet ist.

10. Schaltungsanordnung nach Anspruch 7, **dadurch gekennzeichnet**, daß zwischen den Steueranschluß des Leistungshalbleiterbauelements (2) und der Ausgangsklemme (3) eine Zenerdiode (17) geschaltet ist.

# FIG 1

# FIG 2